# EUROPÄISCHE PATENTSCHRIFT

(11) **EP 3 623 705 B1**
(45) Veröffentlichungstag und Bekanntmachung des Hinweises auf die Patenterteilung: **01.12.2021**
(21) Anmeldenummer: 19196184.6
(22) Anmeldetag: 09.09.2019
(51) Int. Cl.: F24C 7/08, A21B 3/00, F24C 15/00

(54) **GARGERÄT**
COOKING DEVICE
APPAREIL DE CUISSON

(30) Priorität: 11.09.2018 DE 102018215434
(43) Veröffentlichungstag der Anmeldung: 18.03.2020
(73) Patentinhaber: WELBILT Deutschland GmbH, 82436 Eglfing (DE)
(72) Erfinder: WILD, Hannes, 82418 Riegsee (DE); FISCHHABER, Herbert, 82380 Peißenberg (DE); SCHWEBESCH, Frank, 82398 Polling (DE)
(74) Vertreter: Hoefer & Partner Patentanwälte mbB

(56) Entgegenhaltungen:
- EP-A1- 2 639 514
- EP-A1- 2 775 790
- DE-A1-102008 001 675
- DE-A1-102009 031 370
- DE-A1-102013 206 868

## Beschreibung

Die Erfindung betrifft ein Gargerät, insbesondere in Form eines gewerblichen Gargeräts, gemäß dem Oberbegriff des Anspruchs 1. Ein derartiges Gargerät ist aus der EP 2 639 514 A1 bekannt.

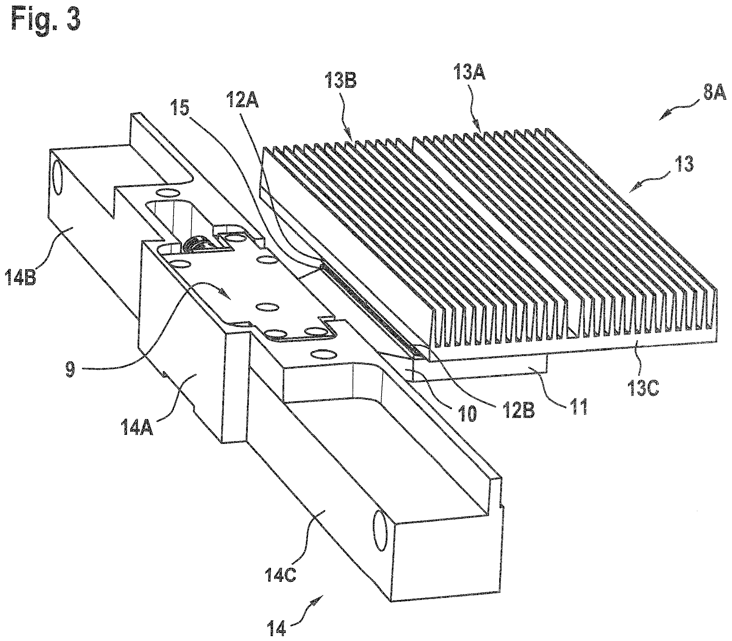

Ein weiteres Gargerät ist beispielsweise aus der DE 10 2004 040 557 A1 bekannt. Diese Druckschrift beschreibt in der Ausführungsform gemäß Fig. 3 die Anordnung eines elektronischen Bauelementes eines Gargerätes auf einem Kopf, der über einen Hals mit der Basis einer Kühleinrichtung verbunden ist, die eine Mehrzahl von Kühlrippen aufweist, die auf der Basis angeordnet sind. Bei der Ausführungsform gemäß Fig. 3 ist diese Anordnung von einem Kanal umgeben, der jedoch nicht über den Kopf und den Hals mit der Basis wärmeleitend verbunden ist.

Ein weiteres Gargerät, das sowohl eine Kamera wie auch ein Kühlsystem aufweist, ist aus der WO 2015/185211 bekannt. Weiterer relevanter Stand der Technik ist aus den Dokumenten DE 10 2013 206868 A1, DE 10 2008 001675 A1, EP 2 775 790 A1 und DE 10 2009 031370 A1 bekannt.

Ausgehend von diesem Stand der Technik ist es Aufgabe der vorliegenden Erfindung, ein Gargerät der im Oberbegriff des Anspruchs 1 angegebenen Art zu schaffen, das eine hohe Kühlleistung ermöglicht und dabei einfach und kompakt aufgebaut ist.

Die Lösung dieser Aufgabe erfolgt durch die Merkmale des Anspruches 1.

Dementsprechend wird ein Gargerät, insbesondere in Form eines gewerblichen Gargeräts geschaffen. Hierbei wird im Rahmen dieser Anmeldung unter dem Begriff "Gargerät" sowohl gewerbliche Gargeräte wie auch Haushalts-Gargeräte und insgesamt ganz allgemein Nahrungsmittel-Behandlungs-Geräte verstanden, die sowohl eine kalte wie auch eine heiße Behandlung von Nahrungsmitteln durchführen können und beispielsweise Heißluftdämpfer, Kombi-Dämpfer, Getränke-Ausgabe-Automaten, Getränke-Mixer, Mikrowellen-Geräte und andere Nahrungsmittel-Behandlungs-Geräte umfassen können.

Das erfindungsgemäße Gargerät weist ein Gehäuse auf, in dem ein Garraum angeordnet ist. Wie üblich kann dieser Garraum mithilfe einer öffnen- und schließbaren Garraumtür geöffnet und geschlossen werden.

Ferner weist das erfindungsgemäße Gargerät eine Sensoreinrichtung auf, die insbesondere zum Auswählen, Führen und/oder Überwachen eines Garprogrammes zur Zubereitung von Gargütern im Garraum vorgesehen sein kann. Ein Beispiel für eine derartige Sensoreinrichtung ist eine Kamera, insbesondere in Form einer digitalen Kamera.

Da sich eine derartige Sensoreinrichtung beim Betrieb erwärmt, was ihre Leistungsfähigkeit herabsetzen kann, weist das erfindungsgemäße Gargerät ferner eine Kühleinrichtung für die Sensoreinrichtung auf, mit der es möglich ist, die Sensoreinrichtung dauerhaft so zu kühlen, so dass sie in einem für eine optimale Leistung liegenden Temperaturbereich gehalten werden kann.

Diese Kühleinrichtung kann ein Kühlgehäuse aufweisen, das aus wärmeleitfähigen, vorzugsweise hoch wärmeleitfähigen, Material aufgebaut ist. Das Kühlgehäuse kann hierbei einen Aufnahmeraum umfassen, in dem die Sensoreinrichtung angeordnet werden kann. Dieser Aufnahmeraum kann bei einer besonders bevorzugten Ausführungsform mittels eines abnehmbaren Deckels nach dem Einbringen der Sensoreinrichtung geschlossen werden.

Ferner weist die Kühleinrichtung eine Wärmeleitbrücke auf, die ebenfalls aus wärmeleitfähigem Material, vorzugsweise hochwärmeleitfähigem Material aufgebaut ist. Diese Wärmeleitbrücke verbindet das Kühlgehäuse mit einem Träger, der ebenfalls aus wärmeleitfähigem und vorzugsweise aus hochwärmeleitfähigem Material aufgebaut ist. Dieser Träger kann beispielsweise eine Trägerplatte sein und vorzugsweise ein Kühlelement lagern. Hierbei ist es möglich, dass das Kühlelement entweder auf dem Träger bzw. der Trägerplatte oder im Träger angeordnet wird.

Schließlich kann die Kühleinrichtung zumindest ein Wärmeableitelement aufweisen, das unmittelbar auf dem zumindest einen Kühlelement angeordnet ist, damit die durch das Kühlelement der Sensoreinrichtung entzogene Wärme abgeleitet werden kann.

Die Sensoreinrichtung kann hierbei an einer geeigneten Stelle im oder am Gerätegehäuse angeordnet werden. Insbesondere ist es auch möglich, die Sensoreinrichtung im Garraum anzuordnen, wobei je nach Anordnung der Sensoreinrichtung an geeigneter Stelle im oder am Gerätegehäuse die Kühleinrichtung angeordnet werden kann, die ein kompaktes und leicht zu händelndes Bauteil darstellt, das je nach Gerätetyp hinsichtlich ihrer Komponenten entsprechend baulich angepasst werden kann, damit ein Einbau im oder am Gerätegehäuse problemlos möglich ist.

Der Aufbau des erfindungsgemäßen Gargerätes macht es möglich, die Sensoreinrichtung (Kamera) von der Kühleinrichtung zu entkoppeln, insbesondere sie örtlich voneinander zu trennen, da der Sensor (Kamera) an einer Stelle am Gargerät montiert ist, an der die Kühleinrichtung nicht untergebracht werden könnte.

Aus der DE 10 2008 001 675 A1 ist zwar ein Kameramodul bekannt, das einen Bildsensorchip und mindestens ein Peltierelement mit einer kühlenden Oberfläche aufweist. Der Bildsensorchip ist mit der kühlenden Oberfläche des Peltierelementes durch mindestens ein Wärmesammelelement verbunden, wohingegen ein Gehäuse, das den Bildsensorchip umgibt, nicht in wärmeleitender Verbindung mit dem Peltierelement steht.

Schließlich ist aus der DE 103 19 176 A1 zwar eine Vorrichtung zur Kühlung einer Kamera bekannt, die einen Bildsensor und eine Verarbeitungseinheit aufweist. Diese Elemente sind thermisch mit einem Ende einer Einrichtung zur Wärmeleitung verbunden, die ihrerseits wärmeleitend mit einem Kühlkörper in Verbindung steht. Das den Bildsensor und die Verarbeitungseinheit umgebende Gehäuse ist auch bei dieser Anordnung nicht wärmeleitend mit dem Kühlkörper gekoppelt.

Die Unteransprüche haben vorteilhafte Weiterbildungen zum Inhalt.

Um einen kompakten und anpassungsfähigen Aufbau der erfindungsgemäßen Kühleinrichtung möglich zu machen, können deren Komponente einstückig miteinander verbunden sein oder es ist alternativ ebenfalls möglich, die Komponenten als separate Bauteile auszubilden, die auf geeignete Art und Weise miteinander verbunden werden können. Als Verbindungstechniken sind Schweißungen, Lötungen oder auch Verklebungen denkbar.

Ferner ist es erfindungsgemäß, dass das Kühlgehäuse in einem Montagegehäuse anzuordnen, das aus einem schlecht wärmeleitfähigen Material, wie beispielsweise Kunststoff, aufgebaut sein kann, um das Kühlgehäuse vor einer Erwärmung durch Wärmeströme von außen zu schützen, die beispielsweise im Küchenbetrieb von anderen wärmeproduzierenden Geräten erzeugt werden können. Ferner ist es möglich, sämtliche temperaturempfindliche Komponenten des erfindungsgemäßen Gargerätes durch zusätzliche Isolierungselemente gegen einen Wärmeeintrag von außen, beispielsweise durch das erwärmte Klima der Küche oder durch weitere in der Küche befindliche Geräte, zu schützen.

Bei einer besonders bevorzugten Ausführungsform ist es möglich, mehr als ein Kühlelement, insbesondere zwei Kühlelemente vorzusehen, die ebenfalls zur Anpassung von baulichen Gegebenheiten üblicherweise beabstandet zueinander angeordnet werden können. Vom Prinzip her ist es natürlich möglich, auch eine größere Anzahl als zwei derartiger Kühlelemente vorzusehen, die in Dimension und Anordnung an die baulichen Gegebenheiten des jeweiligen Gargeräts angepasst werden können.

Um die Wärmeleitung noch weiter zu verbessern, ist es bei einer weiteren bevorzugten Ausführungsform möglich, zwischen dem oder den Kühlelementen und dem Träger eine Schicht aus Leitpaste, Thermofolie oder auch aus einem Wärmeleitkleber vorzusehen, damit die Kühlleistung der erfindungsgemäßen Kühleinrichtung weiter verbessert werden kann.

Eine derartige Schicht aus einer Leitpaste, einer Thermofolie und/oder einem Wärmeleitkleber kann ferner zwischen dem bzw. den Kühlelementen und dem Wärmeableitelement vorgesehen sein.

Bei einer weiteren besonders bevorzugten Ausführungsform weist die erfindungsgemäße Kühleinrichtung ferner einen Lüfter, beispielsweise in Form eines Lüftergebläses, auf, der auf das Wärmeableitelement gerichtet ist, damit der vom Lüfter erzeugte Luftstrom auf das Wärmeableitelement geleitet werden kann, damit dieser Kühlluftstrom die Wärme, die sich im Wärmeableitelement gesammelt hat, mit hoher Effizienz ableiten kann.

Bei einer weiteren besonders bevorzugten Ausführungsform ist es möglich, den Lüfter mit einem Kühlkanal zu kombinieren, in dem das Wärmeableitelement angeordnet werden kann. In diesem Falle wird der Kühler unmittelbar an den Kühlkanal angeschlossen und saugt Kaltluft ab und kann diese Kaltluft durch die Leitfunktion des Kühlkanals noch gezielter auf das Kühlelement, insbesondere auf Kühlrippen dieses Kühlelements, leiten. Nach dem Durchlauf durch das Kühlelement, bei dem sich die Kaltluft erwärmt hat, kann diese über einen Endbereich des Kühlkanals an einer geeigneten Stelle abgeleitet werden kann, was eine weitere Effizienzerhöhung der Kühlung ergibt.

Das Wärmeableitelement kann beispielsweise eine Mehrzahl von Kühlrippen aufweisen, die bei einer besonders bevorzugten Ausführungsform in zwei Kühlrippenblocks unterteilt sein können und beispielsweise auf einer Trägerplatte angeordnet sein können.

Je nach Gerätetyp ist es ferner möglich, das Wärmeableitelement symmetrisch oder insbesondere auch asymmetrisch bezüglich des bzw. der Kühlelemente anzuordnen, um je nach den baulichen und funktionellen Bedingungen des erfindungsgemäßen Gargeräts eine hocheffiziente Kühleinrichtung mit hoher Kühlleistung erreichen zu können.

Ein besonders bevorzugtes Material für alle Komponenten der erfindungsgemäßen Kühleinrichtung mit hoher Wärmeleitfähigkeit ist Aluminium.

Die Kühlelemente sind bevorzugterweise als Peltier-Elemente (TEC) ausgebildet. Alternativ ist es auch möglich, das bzw. die Kühlelemente als Wärmetauscher auszubilden.

Eine weitere Alternative für Kühlelemente könnte beispielsweise ein Wasserkühler sein.

In den Ansprüchen 16 und 17 ist die erfindungsgemäße Kühleinrichtung als selbstständig handelbares Objekt definiert.

Bei allen zuvor beschriebenen Ausführungsbeispielen des erfindungsgemäßen Gargeräts und der erfindungsgemäßen Kühleinrichtung sind natürlich sämtliche erforderlichen Regler, Gerätesteuerungen und Wirkverbindungen, Signalleitungen, Anschlusskabel und, falls erforderlich, Energiequellen zur Stromversorgung vorgesehen und können in der jeweils erforderlichen Kombination implementiert werden.

Weitere Einzelheiten, Vorteile und Merkmale der vorliegenden Erfindung ergeben sich aus nachfolgender Beschreibung von Ausführungsbeispielen anhand der Zeichnung. Darin zeigt:
- Figur 1: eine schematisch stark vereinfachte Prinzipdarstellung einer Ausführungsform eines erfindungsgemäßen Gargeräts,
- Figur 2: eine perspektivische Darstellung einer ersten Ausführungsform der erfindungsgemäßen Kühleinrichtung,
- Figur 3: eine perspektivische Darstellung einer zweiten Ausführungsform der erfindungsgemäßen Kühleinrichtung,
- Figur 4: eine perspektivische Unteransicht der Ausführungsform der Kühleinrichtung gemäß Figur 3,
- Fig. 5: eine der Figur 2 entsprechende Darstellung der ersten Ausführungsform der erfindungsgemäßen Kühleinrichtung, die zur Erläuterung des Vorsehens eines Reglers und einer Gerätesteuerung sowie eines Temperaturfühlers mit entsprechenden Wirk- und Signalleitungen ergänzt ist, und
- Fig. 6: eine weitere Ausführungsform der erfindungsgemäßen Kühleinrichtung.

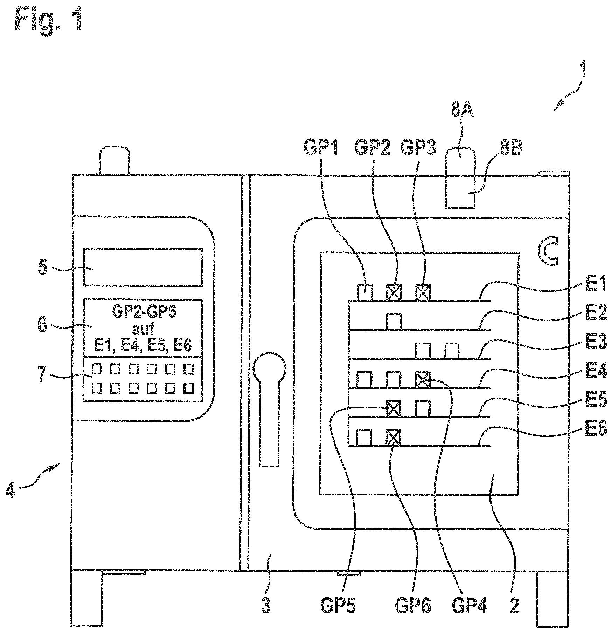

In Figur 1 ist ein erfindungsgemäßes Gargerät 1 dargestellt, das einen Garraum 2 aufweist, der in einem Gehäuse bzw. Gerätegehäuse 4 angeordnet ist. Der Garraum 2 kann über eine öffnen- und schließbare Garraumtür 3 geöffnet bzw. geschlossen werden.

Das Gargerät 1 weist ferner eine Steuereinrichtung 5, eine Anzeigerichtung 6 sowie eine Eingabeeinrichtung 7 auf.

Schließlich ist das Gargerät 1 mit einer Sensoreinrichtung 8B versehen, die in Figur 1 schematisch vereinfacht als Block dargestellt ist. Diese Sensoreinrichtung 8B kann, wie in Figur 1 dargestellt, im Gehäuse 4 oder am Gehäuse 4, beispielsweise an der Frontseite des Gehäuses 4 angeordnet sein. Ferner ist es möglich, die Sensoreinrichtung 8B in der Garraumtür 3 vorzusehen oder im Garraum 2 selber. Ein Beispiel für eine derartige Sensoreinrichtung ist eine Kamera, insbesondere in Form einer Digitalkamera zur Überwachung des Garraums 2, um beispielsweise einen Garvorgang von Garprodukten GP1 bis GP 6 zu überwachen, die auf Gargutebenen E1 bis E6 angeordnet sein können.

Das erfindungsgemäße Gargerät 1 weist ferner eine ebenfalls durch einen Block schematisch stark vereinfacht dargestellte Kühleinrichtung 8A auf, die bei der in Figur 1 dargestellten Ausführungsform beispielhaft auf dem Gehäuse 4 angeordnet ist. Diese Kühleinrichtung 8A kann jedoch alternativ im Gehäuse 4, und dort in einem für die Aufnahme der Kühleirichtung 8A geeigneten Bereich angeordnet werden oder ebenfalls in der Garraumtür 3 vorgesehen sein. Diese Kühleinrichtung 8A dient zur Kühlung der Sensoreinrichtung 8B, um deren Funktion und Effizienz sicherzustellen.

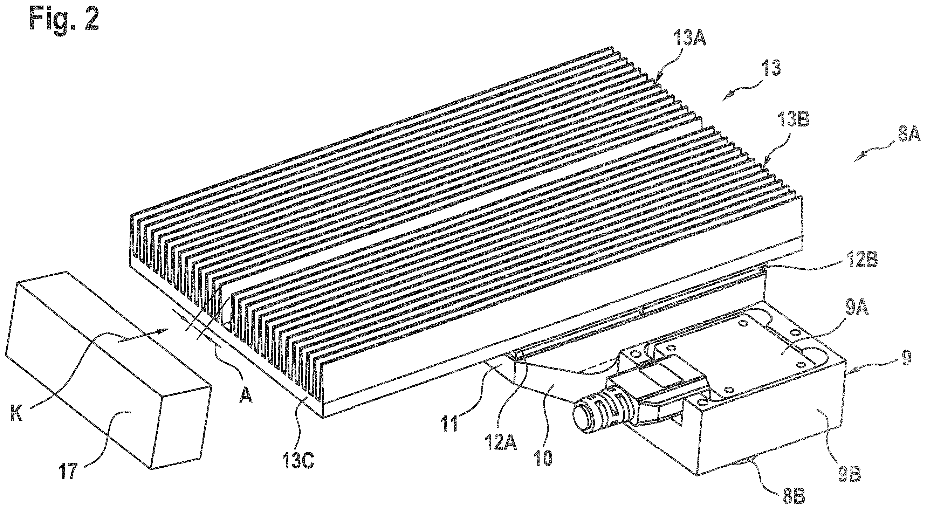

Der Aufbau dieser Kühleinrichtung 8A wird nachfolgend anhand der Detailerstellung in den Figuren 2 bis 4 erläutert.

Die Ausführungsformen der Kühleinrichtung 8A gemäß Figur 2 umfasst ein Kühlgehäuse 9, das aus einem vorzugsweise hochwärmeleitfähigen Material, wie beispielsweise Aluminium, aufgebaut sein kann. Im Kühlgehäuse 9 ist in einem in Figur 2 nicht sichtbaren Aufnahmeraum die Sensoreinrichtung 8B angeordnet, deren unterer aus dem Kühlgehäuse 9 vorragende Teil in Figur 2 sichtbar ist. Der Aufnahmeraum des Kühlgehäuses 9 ist mit einem Deckel 9A verschlossen, der auf einen Gehäusekörper 9B fixiert ist.

Das Kühlgehäuse 9 ist mit einer Wärmeleitbrücke 10 verbunden, die ebenfalls aus einem wärmeleitfähigen, insbesondere hochwärmeleitfähigen Material aufgebaut ist. Diese Wärmeleitbrücken 10 verbindet das Kühlgehäuse 9 mit einem Träger 11, der ebenfalls aus wärmeleitfähigem, vorzugsweise hochwärmeleitfähigem, Material ausgebildet ist. Der Träger 11, der bei der dargestellten Ausführungsform als Trägerplatte ausgebildet ist, lagert zumindest ein Kühlelement, im dargestellten beispielsweise jedoch zwei Kühlelemente 12A und 12B. Diese Kühlelemente 12A und 12B können beispielsweise als Peltier-Elemente ausgebildet sein.

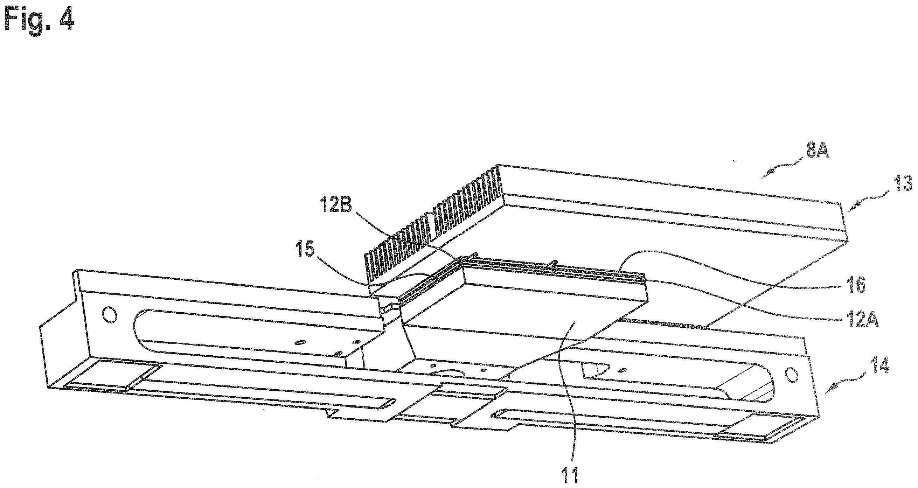

Schließlich weist die Kühleinrichtung 8A ein Wärmeableitelement 13 auf, das im beispielsweise auf den beiden Kühlelementen 12A und 12B angeordnet ist. Vorzugsweise ist dieses Wärmeableitelement 13, wie eingangs bereits erläutert, unmittelbar auf den Kühlelementen 12A und 12B angeordnet und es ist bei einer besonders bevorzugten Ausführungsform möglich, eine Schicht aus Leitpaste, Thermofolie oder Wärmeleitkleber zwischen den Kühlelementen 12A und 12B und dem Wärmeableitelement 13 vorzusehen, die jedoch in Figur 2 nicht sichtbar ist, sodass diese Schicht anhand der Figuren 3 und 4 erläutert werden wird.

Wie Figur 2 ferner verdeutlicht, umfasst bei dieser Ausführungsform das Wärmeableitelement 13 zwei Kühlrippenblöcke 13A und 13B, die auf einer Trägerplatte 13C angeordnet sind und um einen wählbaren Abstand A beabstandet zueinander auf der Trägerplatte 13C angeordnet sind.

Ferner umfasst die Kühleinrichtung 8A der Ausführungsform gemäß Figur 2 einen Lüfter bzw. ein Gebläse 17, das einen Kühlluftstrom K auf die Kühlrippenblöcke 13A und 13B leiten kann, um die der Sensoreinrichtung 8B entzogene Wärme ableiten zu können.

Bei der Ausführungsform gemäß Figur 3 ist zusätzlich zu den zuvor genannten Komponenten der Kühleinrichtung 8A ein Montagegehäuse/Außengehäuse 14 vorgesehen, das einen mittigen Aufnahmebereich 14A für das Kühlgehäuse 9 und zwei daran angrenzende Montageabschnitte 14B und 14C aufweist, mit denen die Kühleinrichtung 8A dieser Ausführungsform im oder am Gehäuse 4 oder innerhalb der Garraumtür 3 fixiert werden kann. Dieses Montagegehäuse 14 ist aus einem Material, wie beispielsweise Kunststoff, aufgebaut, der schlecht wärmeleitfähig ist und gegebenenfalls mit weiteren Wärmeisolierelementen ausgestattet ist, damit das Montagegehäuse 14 einen Wärmeeintrag in das Kühlgehäuse 9 verhindern kann, der beispielsweise in einer Küche, in der das erfindungsgemäße Gargerät 1 betrieben wird, durch andere Geräte oder heiße Gargutdämpfe entstehen kann. Der in Figur 3 dargestellte Aufbau des Montagegehäuses 14 ist rein beispielhaft und kann an das jeweilige Gargerät 1 hinsichtlich seiner Dimensionierung und Formgebung angepasst werden, damit die Kühleinrichtung 8A im oder am Gehäuse 4 oder in der Garraumtür 3 angeordnet werden kann.

In Figur 3 ist ferner eine Schicht 15 sichtbar, die die zuvor erläuterte Schicht aus Leitpaste, Thermofolie oder Wärmeleitkleber ist, die jedoch in Figur 2 nicht sichtbar war.

Figur 4 stellt die Unteransicht der Ausführungsform gemäß Figur 3 dar, die verdeutlicht, dass es möglich ist, zwei derartige Schichten 15 und 16 aus Leitpaste, Thermofolie oder Wärmeleitkleber vorzusehen, wobei die Schicht 16 zwischen den Kühlelementen 12A und 12B und dem Wärmeableitelement 13 vorgesehen ist. Ferner ist es auch hier möglich, eine Leitpaste, Thermofolie oder einen Wärmeleitkleber zwischen der Kamera bzw. Sensoreinrichtung 8B und dem Kühlgehäuse 9 vorzusehen.

Die Ausführungsform der Kühleinrichtung 8A gemäß den Figuren 3 und 4 kann natürlich ebenfalls mit einem Lüfter 17, wie er in Figur 2 schematisch vereinfacht dargestellt ist, kombiniert werden. Falls bei Gargeräten ein Kühlluftstrom zur Verfügung steht, der ohne einen derartigen Lüfter 17, beispielsweise aufgrund der Bauart des Gargerätes 1 erzeugbar ist, ist es nicht zwingend nötig, dass die Kühleinrichtung 8A mit einem derartigen Lüfter 17 zusammenwirkt.

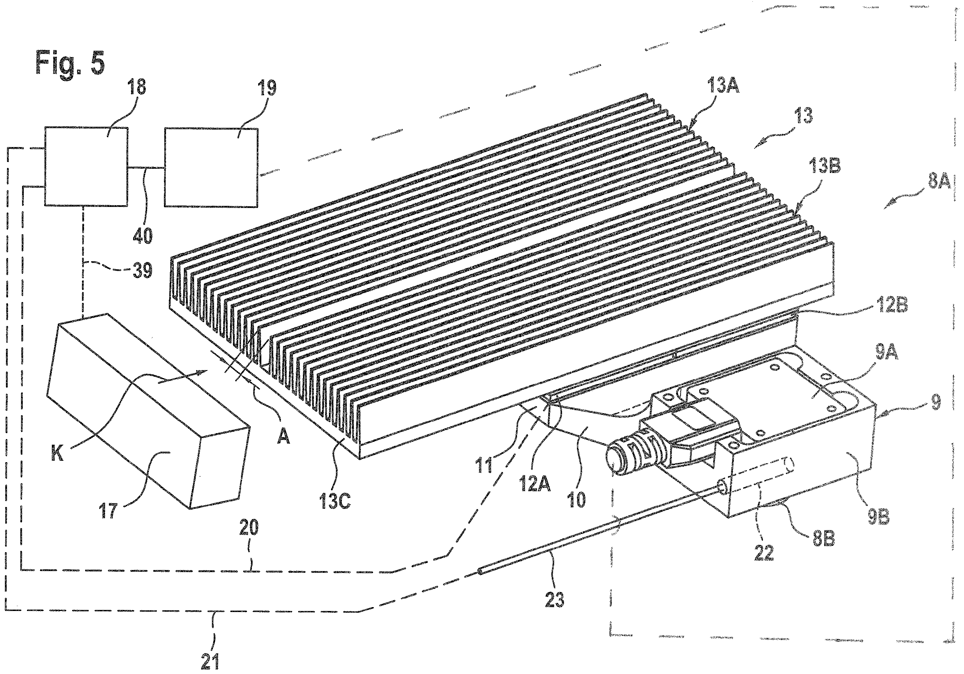

Figur 5 entspricht der Darstellung der Figur 2, so dass hinsichtlich aller übereinstimmenden Merkmale auf die vorangehende Beschreibung verwiesen werden kann.

In Figur 5 ist beispielhaft schematisch vereinfacht dargestellt, dass das erfindungsgemäße Gargerät 1 und dessen Kühleinrichtung 8A neben den zuvor bereits beschriebenen Komponenten natürlich bei jeder denkbaren Ausführungsform mit einem Regler 18 versehen sein kann, der mit einer Gerätesteuerung 19 über eine Wirkverbindungsleitung 25 in Wirkverbindung steht.

Die gestrichelten Linien 20 und 21 stellen Wirkverbindungen zwischen dem Regler 18 und dem bzw. den Peltier-Elementen 12A bzw. eine Fühlersignalleitung zu einem Temperaturfühler 22 dar, der über ein Kabel 23 mit der Signalleitung 21 verbunden ist und im Kühlgehäuse 9 angeordnet ist. Dieser Temperaturfühler 22 misst die Innentemperatur des Kühlgehäuses 9, um zu überwachen, ob die Sensoreinrichtung 8B in einem tolerablen Temperaturumfeld arbeitet oder ob die Aktivierung der Kühlung erforderlich ist, um eine Überhitzung zu vermeiden.

Über die Leitung 20 können die Peltier-Elemente 12A, 12B, falls als Kühlelemente derartige Elemente vorgesehen sind, angesteuert werden.

Die Verbindungsleitung 39 zwischen dem Regler 18 und dem Lüfter 17 ermöglicht es, diesen ein- bzw. auszuschalten.

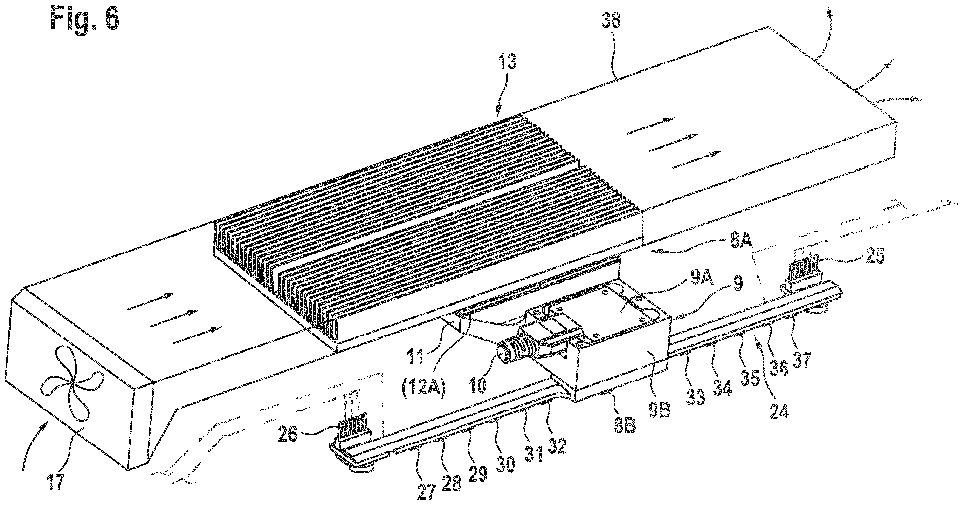

In Figur 6 ist eine weitere Ausführungsform der erfindungsgemäßen Kühleinrichtung 8A dargestellt. Diese entspricht im Wesentlichen der Ausführungsform gemäß Figur 2, so dass hinsichtlich aller übereinstimmenden Merkmale auf deren Beschreibung Bezug genommen werden kann.

Als weiteres Merkmal ist bei dieser Ausführungsform jedoch eine Kühlleiste 24, beispielsweise aus Aluminium, vorgesehen, die mit dem Kühlgehäuse 9 verbunden ist. An der Unterseite dieser Kühlleiste 24 können Lichtquellen, beispielsweise in Form von LEDs, vorgesehen sein, die in Figur 6 durch die Bezugszeichen 27 bis 37 symbolisiert sind.

An den beiden Endbereichen der Kühlleiste 24 sind ferner zwei Höhenmesser 25 und 26 angeordnet, mit denen es möglich ist, zu bestimmen, auf welcher Ebene Gargutträger in den Garraum eingebracht werden. Diese Höhenmesser stehen natürlich mit dem zuvor anhand Figur 5 erläuterten Regler 18 und der Gerätesteuerung 19 in Wirkverbindung, wobei die Lichtquellen über den Regler ein- und ausgeschaltet werden können.

Ferner ist es bei dieser Ausführungsform möglich, vom Kühlgehäuse 9 aus jeweils in Richtung der beiden Höhenmesser 25 bzw. 26 verschiedene Temperaturzonen über die Geometrie der Kühlleiste 24 einzustellen, da in dieser Richtung, also vom Kühlgehäuse 9 zu den beiden Höhensensoren 25 bzw. 26, die Temperatur zunimmt.

Ferner zeichnet sich die Ausführungsform der Figur 6 dadurch aus, dass der Lüfter bzw. das Gebläse 17 mit einem Kühlkanal 38 zusammenwirkt. Bei der dargestellten Ausführungsform ist das Gebläse 17 am Eingang des Kühlkanals 38 angeordnet und das Wärmeableitelement 13 ist, entfernt vom Gebläse 17 im Kühlkanal 38 angeordnet, wie sich dies aus der Prinzipdarstellung der Figur 6 ergibt.

Somit ist es bei dieser Ausführungsform möglich, über das Gebläse 17 Frischluft anzusaugen und diese im Kühlkanal 38 über das Wärmeableitelement 13 zu leiten und am gegenüberliegenden Ende die erwärmte Luft in einem geeigneten Bereich im oder außerhalb des erfindungsgemäßen Gargerätes 1 abzuführen. Dies erhöht weiter die Effizienz der Kühlleistung der erfindungsgemäßen Kühleinrichtung 8A.

Bei dieser Ausführungsform ist es ferner möglich, durch das Vorsehen der Kühlleiste 24 auf ein oder mehrere Kühlelemente zu verzichten, was in Figur 6 dadurch symbolisiert ist, dass die Bezugsziffer 12A in Klammern gesetzt ist. Sollte es erforderlich sein, ist natürlich auch eine Kombination von einem oder mehreren Kühlelementen 12A, 12B mit der Kühlleiste 24 möglich.

Neben der voranstehenden schriftlichen Offenbarung wird hiermit zur Ergänzung der Offenbarung explizit auf die Darstellung der Erfindung in den Figuren 1 bis 6 Bezug genommen.

### Bezugszeichenliste

- 1: Gargerät
- 2: Garraum
- 3: Garraumtür
- 4: Gehäuse/Gerätegehäuse
- 5: Steuereinrichtung
- 6: Anzeigeeinrichtung/Display
- 7: Eingabeeinrichtung/Tastatur
- 8A: Kühleinrichtung
- 8B: Sensoreinrichtung
- E1 bis E6: Gargutebenen
- GP1 bis GP6: Garprodukte
- 9: Kühlgehäuse
- 9A: Deckel
- 9B: Gehäusekörper
- 10: Wärmeleitbrücke
- 11: Träger/Trägerplatte
- 12A, 12B: Kühlelement
- 13: Wärmeableitelement
- 13A, 13B: Kühlrippenblöcke
- 14: Montagegehäuse/Außengehäuse
- 14A: Aufnahmebereich
- 14B, 14C: Montagebereich
- 15, 16: Schichten
- 17: Lüfter/Gebläse
- 18: Regler
- 19: Gerätesteuerung
- 20, 21: Wirkverbindung/Signalverbindung
- 22: Temperaturfühler
- 23: Kabel
- 24: Kühlleiste
- 25,26: Höhensensor
- 27-37: Lichtquellen/LEDs
- 38: Kühlkanal
- 39, 40: Wirkverbindung/Signalverbindung
- K: Kühlluftstrom
- A: Abstand zwischen den Kühlrippenblöcken 13A und 13B

## Patentansprüche

1. Gargerät (1), insbesondere gewerbliches Gargerät
- mit einem Gehäuse (4), in dem ein Garraum (2) angeordnet ist;
- mit zumindest einer Sensoreinrichtung (8B); und
- mit einer Kühleinrichtung (8A) für die Sensoreinrichtung (8B), die folgende Komponenten umfasst:
- ein Kühlgehäuse (9), in dem die Sensoreinrichtung (8B) angeordnet ist,
- eine Wärmeleitbrücke (10), und
- zumindestens ein Wärmeableitelement (13), das auf einem Träger (11) angeordnet ist,
- wobei das Kühlgehäuse (9) aus wärmeleitfähigem, vorzugsweise hochwärmeleitfähigem Material, besteht, und
- wobei die Wärmeleitbrücke (10) aus wärmeleitfähigem, vorzugsweise hochwärmeleitfähigem, Material das Kühlgehäuse (9) mit dem Träger (11) aus wärmeleitfähigem, vorzugsweise hochwärmeleitfähigem Material verbindet,
**dadurch gekennzeichnet, dass** der Träger (11) zumindest ein Kühlelement (12A, 12B) lagert, wobei das zumindest eine Wärmeableitelement (13) auf dem zumindest einen Kühlelement (12A, 12B) angeordnet ist,
und **dadurch gekennzeichnet, dass** das Kühlgehäuse (9) in einem Montagegehäuse (14) aus schlecht wärmeleitfähigem Material, insbesondere Kunststoff, angeordnet ist.

2. Gargerät nach Anspruch 1, **dadurch gekennzeichnet, dass** das Kühlgehäuse (9), die Wärmeleitbrücke (10) und der Träger (11) einstückig ausgebildet sind oder dass das Kühlgehäuse (9), die Wärmeleitbrücke (10) und der Träger (11) separate Komponenten sind, die miteinander verbunden, insbesondere verschweißt, verklebt oder verlötet, sind.

3. Gargerät nach einem der Ansprüche 1 oder 2, **dadurch gekennzeichnet, dass** im oder um das Kühlgehäuse (9) herum zusätzlich Wärmeisolierelemente vorgesehen sind.

4. Gargerät nach einem der Ansprüche 1 bis 3, **dadurch gekennzeichnet, dass** zwei Kühlelemente (12A, 12B) vorgesehen sind, die vorzugsweise beabstandet zueinander angeordnet sind oder die unmittelbar nebeneinander angeordnet sind.

5. Gargerät nach einem der Ansprüche 1 bis 4, **dadurch gekennzeichnet, dass** zwischen dem zumindest einen Kühlelement (12A, 12B) und dem Träger (11) eine Schicht (15) aus Leitpaste, Thermofolie oder Wärmeleitkleber vorgesehen ist.

6. Gargerät nach einem der Ansprüche 1 bis 5, **dadurch gekennzeichnet, dass** zwischen dem zumindest einen Kühlelement (12A, 12B) und dem Wärmeableitelement (13) eine Schicht (16) aus Leitpaste, Thermofolie oder Wärmeleitkleber vorgesehen ist.

7. Gargerät nach einem der Ansprüche 1 bis 6, **dadurch gekennzeichnet, dass** die Kühleinrichtung (8A) einen Lüfter (17) aufweist, der auf das Wärmeableitelement (13) gerichtet ist, der vorzugsweise an einem Luftleitkanal bzw. Kühlkanal (38) angeordnet ist, in dem das Wärmeableitelement (13) platzierbar ist.

8. Gargerät nach einem der Ansprüche 1 bis 7, **dadurch gekennzeichnet, dass** das wärmeleitfähige Material Aluminium ist.

9. Gargerät nach einem der Ansprüche 1 bis 8, **dadurch gekennzeichnet, dass** das Wärmeableitelement (13) eine Mehrzahl von Kühlrippen aufweist.

10. Gargerät nach Anspruch 9, **dadurch gekennzeichnet, dass** die Kühlrippen in zwei Kühlrippenblocks (13A, 13B) aufgeteilt sind.

11. Gargerät nach Anspruch 9 oder 10, **dadurch gekennzeichnet, dass** die Kühlrippen auf einer Trägerplatte (13C) angeordnet sind.

12. Gargerät nach einem der Ansprüche 1 bis 11, **dadurch gekennzeichnet, dass** das Wärmeableitelement (13) symmetrisch oder asymmetrisch bezüglich des zumindest einen Kühlelements (12A, 12B) angeordnet ist.

13. Gargerät nach einem der Ansprüche 1 bis 12, **dadurch gekennzeichnet, dass** das zumindest eine Kühlelement (12A, 12B) als Peltier-Element ausgebildet ist.

14. Gargerät nach einem der Ansprüche 1 bis 12, **dadurch gekennzeichnet, dass** das zumindest eine Kühlelement (12A, 12B) als Wärmetauscher ausgebildet ist.

## Claims

1. Cooking appliance (1), in particular commercial cooking appliance, comprising
- a housing (4) in which a cooking space (2) is arranged;
- at least one sensor device (8B); and
- a cooling device (8A) for the sensor device (8B), comprising the following components:
- a cooling housing (9), in which the sensor device (8B) is arranged,
- a heat conducting bridge (10), and
- -at least one heat dissipating element (13) arranged on a carrier (11),
- wherein the cooling housing (9) consists of thermally conductive, preferably highly thermally conductive material, and
- wherein the heat-conducting bridge (10) made of heat-conducting, preferably highly heat-conducting material connects the cooling housing (9) to the carrier (11) made of heat-conducting, preferably highly heat-conducting material,
**characterized in that** the carrier (11) supports at least one cooling element (12A, 12B), the at least one heat dissipating element (13) being arranged on the at least one cooling element (12A, 12B),
and **characterized in that** the cooling housing (9) is arranged in a mounting housing (14) made of poorly heat-conducting material, in particular plastic.

2. Cooking appliance according to claim 1, **characterized in that** the cooling housing (9), the heat conducting bridge (10) and the carrier (11) are integrally formed, or that the cooling housing (9), the heat conducting bridge (10) and the carrier (11) are separate components which are connected to one another, in particular welded, glued or soldered.

3. Cooking appliance according to one of claims 1 or 2, **characterized in that** additional heat insulating elements are provided in or around the cooling housing (9).

4. Cooking appliance according to one of claims 1 to 3, **characterized in that** two cooling elements (12A, 12B) are provided which are preferably arranged spaced apart from one another, or which are arranged immediately adjacent to one another.

5. Cooking appliance according to one of the claims 1 to 4, **characterized in that** a layer (15) of conductive paste, thermal foil or thermally conductive adhesive is provided between the at least one cooling element (12A, 12B) and the support (11).

6. Cooking appliance according to one of claims 1 to 5, **characterized in that** a layer (16) of conductive paste, thermal foil or thermally conductive adhesive is provided between the at least one cooling element (12A, 12B) and the heat dissipating element (13).

7. Cooking appliance according to any one of claims 1 to 6, **characterized in that** the cooling device (8A) comprises a fan (17) directed towards the heat dissipating element (13), which is preferably arranged on an air conduction channel and a cooling channel (38), respectively, in which the heat dissipating element (13) can be placed.

8. Cooking appliance according to one of the claims 1 to 7, **characterized in that** the heat-conducting material is aluminum.

9. Cooking appliance according to any one of claims 1 to 8, **characterized in that** the heat dissipating element (13) has a plurality of cooling fins.

10. Cooking appliance according to claim 9, **characterized in that** the cooling fins are divided into two cooling fin blocks (13A, 13B).

11. Cooking appliance according to claim 9 or 10, **characterized in that** the cooling fins are arranged on a support plate (13C).

12. Cooking appliance according to one of the claims 1 to 11, **characterized in that** the heat dissipation element (13) is arranged symmetrically or asymmetrically with respect to the at least one cooling element (12A, 12B).

13. Cooking appliance according to one of claims 1 to 12, **characterized in that** the at least one cooling element (12A, 12B) is designed as a Peltier element.

14. Cooking appliance according to one of claims 1 to 12, **characterized in that** the at least one cooling element (12A, 12B) is designed as a heat exchanger.

## Revendications

1. Appareil de cuisson (1), en particulier appareil de cuisson commercial
- avec un boîtier (4), dans lequel un espace de cuisson (2) est agencé ;
- avec au moins un dispositif capteur (8B) ; et
- avec un dispositif de refroidissement (8A) pour le dispositif capteur (8B) qui comporte les composants suivants :
- un boîtier de refroidissement (9) dans lequel le dispositif capteur (8B) est agencé,
- un pont thermoconducteur (10), et
- au moins un élément dissipateur de chaleur (13) qui est agencé sur un support (11),
- dans lequel le boîtier de refroidissement (9) se compose de matériau thermoconducteur, de préférence à haute conduction thermique, et
- dans lequel le pont thermoconducteur (10) en matériau thermoconducteur, de préférence à haute conduction thermique relie le boîtier de refroidissement (9) au support (11) en matériau thermoconducteur, de préférence à haute conduction thermique,
**caractérisé en ce que** le support (11) loge au moins un élément de refroidissement (12A, 12B), dans lequel l'au moins un élément dissipateur de chaleur (13) est agencé sur l'au moins un élément de refroidissement (12A, 12B),
et **caractérisé en ce que** le boîtier de refroidissement (9) est agencé dans un boîtier de montage (14) en matériau à mauvaise conduction thermique, en particulier en matière plastique.

2. Appareil de cuisson selon la revendication 1, **caractérisé en ce que** le boîtier de refroidissement (9), le pont thermoconducteur (10) et le support (11) sont réalisés d'un seul tenant ou que le boîtier de refroidissement (9), le pont thermoconducteur (10) et le support (11) sont des composants séparés qui sont reliés entre eux, en particulier soudés, collés ou brasés.

3. Appareil de cuisson selon l'une quelconque des revendications 1 ou 2, **caractérisé en ce que** des éléments d'isolation thermique sont en outre prévus dans ou autour du boîtier de refroidissement (9).

4. Appareil de cuisson selon l'une quelconque des revendications 1 à 3, **caractérisé en ce que** deux éléments de refroidissement (12A, 12B) sont prévus, lesquels sont agencés de préférence à distance l'un de l'autre ou sont agencés directement l'un à côté de l'autre.

5. Appareil de cuisson selon l'une quelconque des revendications 1 à 4, **caractérisé en ce qu'**une couche (15) de pâte conductrice, film thermique ou colle thermoconductrice est prévue entre l'au moins un élément de refroidissement (12A, 12B) et le support (11).

6. Appareil de cuisson selon l'une quelconque des revendications 1 à 5, **caractérisé en ce qu'**une couche (16) de pâte conductrice, film thermique ou colle thermoconductrice est prévue entre l'au moins un élément de refroidissement (12A, 12B) et l'élément dissipateur de chaleur (13).

7. Appareil de cuisson selon l'une quelconque des revendications 1 à 6, **caractérisé en ce que** le dispositif de refroidissement (8A) présente un ventilateur (17) qui est dirigé sur l'élément dissipateur de chaleur (13) qui est agencé de préférence au niveau d'un canal de conduite d'air ou canal de refroidissement (38), dans lequel l'élément dissipateur de chaleur (13) peut être placé.

8. Appareil de cuisson selon l'une quelconque des revendications 1 à 7, **caractérisé en ce que** le matériau thermoconducteur est de l'aluminium.

9. Appareil de cuisson selon l'une quelconque des revendications 1 à 8, **caractérisé en ce que** l'élément dissipateur de chaleur (13) présente une pluralité de nervures de refroidissement.

10. Appareil de cuisson selon la revendication 9, **caractérisé en ce que** les nervures de refroidissement sont divisées en deux blocs de nervure de refroidissement (13A, 13B).

11. Appareil de cuisson selon la revendication 9 ou 10, **caractérisé en ce que** les nervures de refroidissement sont agencées sur une plaque porteuse (13C).

12. Appareil de cuisson selon l'une quelconque des revendications 1 à 11, **caractérisé en ce que** l'élément dissipateur de chaleur (13) est agencé de manière symétrique ou asymétrique par rapport à l'au moins un élément de refroidissement (12A, 12B).

13. Appareil de cuisson selon l'une quelconque des revendications 1 à 12, **caractérisé en ce que** l'au moins un élément de refroidissement (12A, 12B) est réalisé en tant qu'élément de Peltier.

14. Appareil de cuisson selon l'une quelconque des revendications 1 à 12, **caractérisé en ce que** l'au moins un élément de refroidissement (12A, 12B) est réalisé en tant qu'échangeur de chaleur.
